# EUROPÄISCHE PATENTSCHRIFT

(11) **EP 2 069 550 B1**
(45) Veröffentlichungstag und Bekanntmachung des Hinweises auf die Patenterteilung: **26.10.2011**
(21) Anmeldenummer: 07818266.4
(22) Anmeldetag: 20.09.2007
(51) Int. Cl.: C23C 14/20, B60Q 3/04, G09F 13/08, H01H 9/18

(54) **ANZEIGE- UND/ODER BEDIENELEMENT IN EINEM KRAFTFAHRZEUG**
DISPLAY AND/OR CONTROL ELEMENT IN A MOTOR VEHICLE
ÉLÉMENT D'AFFICHAGE ET/OU DE COMMANDE DANS UN VÉHICULE AUTOMOBILE

(30) Priorität: 22.09.2006 DE 102006045335
(43) Veröffentlichungstag der Anmeldung: 17.06.2009
(73) Patentinhaber: PREH GmbH, 97616 Bad Neustadt (DE)
(72) Erfinder: LUST, Matthias, 74072 Heilbronn (DE); JEITNER, Martin, 97645 Ostheim (DE); KÜCHLER, Wolfgang, 97645 Ostheim (DE); SCHRÖDER, Dietmar, 97618 Wülfershausen (DE)
(74) Vertreter: Bauer, Wulf
(86) Internationale Anmeldenummer: PCT/EP2007/008174
(87) Internationale Veröffentlichungsnummer: WO 2008/034610

(56) Entgegenhaltungen:
- EP-A- 1 217 491
- DE-A1- 19 630 734
- DE-B3-102005 032 717

## Beschreibung

Die Erfindung betrifft eine Kappe für ein Anzeige- oder Bedienelement nach dem Oberbegriff des Anspruchs 1.

Eine derartige Kappe ist aus der DE 10 2005 032 717 B3 bekannt.

Die Kappe ist insbesondere eine Taste, zum Beispiel für die Verwendung in einem Kraftfahrzeug. Die Kappe weist einen Kappenkörper und eine im Kappenkörper angeordnete Leucht- beziehungsweise Projektionsfläche auf, die bei bestimmungsgemässen Gebrauch und Anordnung der Kappe als Teil eines Anzeigeoder Bedienelements für den Bediener aufgrund einer unter der Abdeckung angeordneten Lichtquelle sichtbar ist. Die Leucht- oder Projektionsfläche dient allgemein der Darstellung eines hinterleuchteten Symbols, das beispielsweise den Bediener darüber informiert, welche Vorrichtung mit dem Bedienelement bedienbar ist, beispielsweise das Klimagerät in einem Fahrzeug. Ferner kann die Leuchtoder Projektionsfläche dazu dienen, über den Schaltzustand des Bedienelements beziehungsweise den Schaltzustand der mit dem Bedienelement geschalteten Vorrichtungen zu informieren, oder sie kann dazu dienen, über mit dem Anzeigeoder Bedienelement in Zusammenhang stehende Zustände der Vorrichtungen zu informieren, um so beispielsweise eine Störung der mit dem Anzeigeoder Bedienelement verbundenen Vorrichtung anzuzeigen.

Aus der EP 1 217 491 A1 ist ein von ihrer Rückseite her durchleuchtbare Bedientaste, insbesondere für ein Autoradio, bekannt, welche einen Grundkörper aus einem durchsichtigen Material hat, auf dem einseitig eine lichtundurchlässige Beschichtung aufgebracht ist, die zur Erzeugung einer Kennzeichnung zumindest eine Durchbrechung aufweist. Die lichtundurchlässige Beschichtung ist auf der Rückseite des Grundkörpers vorgesehen.

Aus der DE 196 30 734 A1 ist eine Anzeigeeinrichtung mit einer vorderen Seite, einer hinteren Seite und einem Anzeigebereich bekannt, die folgende Elemente aufweist: eine Schalttafel, eine erste LED-Reihe, eine Linsenreihe, eine Decklinse oder ein Deckglas, das auf der Linsenreihe an der vorderen Seite der Anzeigeeinrichtung angeordnet ist und eine zweite LED-Reihe, wobei die Decklinse einfallendes Licht von der Mehrzahl von LEDs der zweiten LED-Reihe zur Linsenreihe an der vorderen Seite der Anzeigeeinrichtung weiterleitet.

Aus der DE 10 2005 006 459 A1 ist bekannt, ein Anzeigeelement aus einem transparenten oder durchscheinenden Kunststoff in einem Teilbereich mittels einer haftvermittelnden Schicht mit einer Metallbeschichtung zu versehen, wobei die haftvermittelnde Schicht, die beispielsweise mittels PVD-Beschichtung (PVD = Physical Vapor Deposition) aufgebracht wurde, teilweise mittels Laser entfernt wurde, um bei Hinterleuchtung ein Symbol zu erzeugen. Die Metallbeschichtung ist opak.

Auch die DE 102 08 674 A1 beschreibt ein Verfahren zur Herstellung eines vorderseitig und zudem galvanisch beschichteten Bedien-, Dekor- oder Anzeigeelements, wobei ein transparenter oder durchscheinender Kunststoffkörper mit einer Metallschicht versehen wird, die partiell zur Erzeugung des Symbols abgetragen wird. Die Metallschicht wird nicht durchleuchtet. Zudem sind beide Verfahren vergleichsweise aufwändig. Ferner wirft die zum Betrachter beziehungsweise Bediener gewandte Metallschicht das Problem auf, dass sie vergleichsweise empfindlich gegenüber Reinigungsmitteln und Körperschweiß ist, so dass meist vorgeschlagen wird, einen zusätzlichen Schutzlack vorzusehen. Zudem ist das Symbol bei den so hergestellten Bedien- oder Anzeigekappen meist auch bei Tageslicht, insbesondere bei direkter Sonnenlichteinwirkung, schon gut sichtbar, und damit ist für den Bediener bei dieser Beleuchtung nicht erkennbar, ob das Symbol tatsächlich leuchtet oder nicht, das heißt beispielsweise ob die mit dem Bedienelement geschaltete Vorrichtung eingeschaltet ist oder nicht oder ob eine Störung vorliegt oder nicht. Dieses Problem tritt zudem verstärkt auf, wenn der Betrachter sich nicht unmittelbar frontal vor der Leucht- beziehungsweise Projektionsfläche sondern sich seitlich versetzt dazu befindet. Da somit bei nicht allen möglichen Lichtverhältnissen und insbesondere bei Betrachtungswinkeln der Unterschied zwischen Such- und Funktionsbeleuchtung im Anzeigebereich gut zu erkennen ist, ist die Informationsübertragung nicht zuverlässig, da Fehlinformationen nicht bei allen Lichtverhältnissen vermieden werden können. Dies ist bei einem Kraftfahrzeug nicht nur aus sicherheitstechnischen Überlegungen bedenklich, sondern erschwert auch die Überwachung von Anzeige- und Bedienelementen durch einen Beifahrer. Beispielsweise sollte der Beifahrer auch in der Lage sein, die Heizungs- und Klimasteuerungsanzeige- und -Bedienelemente gut zu erkennen.

Zudem weist allgemein ein trotz ausgeschalteter Lichtquelle des Bedienelements immer noch sichtbares Symbol auf der Leucht- beziehungsweise Projektionsfläche den Nachteil auf, dass der Bediener mit im Moment nicht relevanter Information überhäuft wird. Um dies zu vermeiden, ist neben der ästhetisch vorteilhaften Wirkung eine bei ausgeschalteter Lichtquelle möglichst unauffälliges, das heißt nicht in Erscheinung tretendes Symbol auf der Licht- beziehungsweise Projektionsfläche erwünscht.

Aus der DE 103 37 456 A1 ist bekannt, ein Bauteil mit einer teillichtdurchlässigen Metallbeschichtung zur Erzeugung eines optischen Effekts zu versehen. Es handelt sich jedoch nicht um ein hinterleuchtetes Bedien- oder Anzeigeelement.

Aus der Anmeldung DE 10 2007 029 314.5 der Anmelderin ist eine Kappe für ein Anzeige- oder Bedienelement mit lichtdurchlässiger Metallbeschichtung bekannt, bei der die Metallbeschichtung auf einer transparenten oder durchscheinenden Lackschicht aufgebracht ist, wobei diese Lackschicht zu dem Zweck vorgesehen ist, eine ebene Fläche für die Metallbeschichtung bereitzustellen. Es hat sich jedoch für die Erfinder überraschend gezeigt, dass die Erkennbarkeit des Symbols bei seitlicher Betrachtung, das heißt bei einer zur senkrechten Betrachtungsrichtung schrägen Betrachtungsrichtung, noch deutlich verbesserungsfähig ist.

Es ist daher Aufgabe der vorliegenden Erfindung, eine Kappe für ein Bedienelement beziehungsweise ein zugehöriges Bedienelement bereitzustellen, bei dem die Darstellung des auf der Leucht- beziehungsweise Projektionsfläche wiedergegebenen Symbols bei seitlicher Betrachtung verbessert ist, das zudem preiswert herzustellen und haltbar ist. Diese Aufgabe wird durch eine Kappe gemäß Anspruch 1, beziehungsweise ein Anzeige- und/oder Bedienelement gemäß Anspruch 8 beziehungsweise 9 gelöst. Ein zugehöriges Herstellungsverfahren, sowie eine vorteilhafte Verwendung sind Gegenstand der nebengeordneten Ansprüche. Die Unteransprüche betreffen jeweils vorteilhafte Ausgestaltungen.

Die erfindungsgemäße Kappe ist für eine Anzeige- oder Bedienelement bestimmt und ist beispielsweise für die Abdeckung eines reinen Anzeigeelements mit Lichtquelle vorgesehen oder dient zusätzlich der Abdeckung und Betätigung eines Schalters eines zugehörigen Bedienelements, das mit einer Anzeigevorrichtung kombiniert ist.

Somit bildet die Kappe beispielsweise wenigstens mit dem Schalter das zugehörige Bedienelement. Die Kappe ist beispielsweise in ein Bedien- oder Anzeigefeld oder ein Armaturenbrett eines Kraftfahrzeugs integriert. Beispielsweise handelt es sich bei dem zugehörigen Schalter um einen Tastschalter, Drehschalter usw..

In dem Kappenkörper ist eine Leucht- beziehungsweise Projektionsfläche vorgesehen, die so ausgestaltet ist, dass durch Bestrahlung durch eine schalterseitig beziehungsweise innenseitig angeordnete Lichtquelle, beispielsweise eine Leuchtdiode, ein auf der Leucht- beziehungsweise auf der Projektionsfläche dargestelltes Symbol, beispielsweise ein Schriftzeichen, ein Schriftzug oder ein Piktogramm, für einen Betrachter beziehungsweise Bediener des Anzeige- beziehungsweise Bedienelements, beispielsweise den Fahrer, sichtbar wird. Die Leuchtbeziehungsweise Projektionsfläche der erfindungsgemäßen Kappe umfasst eine lichtdurchlässige, das heißt somit auch teillichtdurchlässige, Metallbeschichtung. Der Grad der Lichtdurchlässigkeit und die auf der Innenseite der Kappe vorgesehene Lichtquelle beziehungsweise deren Lichtintensität und/oder deren Spektrum sind so gewählt, dass zwar das vergleichsweise intensive Licht der Lichtquelle durchgelassen wird und damit der Betrachter das beleuchtete Symbol gut erkennen kann, andererseits aber der Reflexionsgrad der Metallbeschichtung für eine ausreichende Reflexion des Umgebungslichts sorgt. Letzteres führt dazu, dass bei ausgeschalteter Lichtquelle, die Leucht- beziehungsweise Projektionsfläche beziehungsweise deren Symbol nahezu gar nicht in Erscheinung tritt (Spiegelbrilleneffekt). Die Metallbeschichtung sorgt erfindungsgemäß dafür, dass der Unterschied auch bei besonders hoher Umgebungslichtintensität zwischen beleuchtetem und nicht beleuchtetem Symbol besonders deutlich zu erkennen ist. Da der Bediener beziehungsweise Betrachter diesen Unterschied sicher erkennen kann, können vorteilhaft Fehlinformationen vermieden werden.

Erfindungsgemäß zeichnet sich die Kappe dadurch aus, dass die Metallbeschichtung eine dreidimensionale Kontur zur Darstellung des Symbols aufweist. Das heißt, die Metallbeschichtung weist im Schnitt ein Profil auf, das sich nicht auf eine im Wesentlichen ebene Ausbreitung der Metallbeschichtung beschränkt, sondern sich senkrecht zu der zum Bediener gewandten Oberfläche der Kappe absenkt oder erhebt, wobei zur zuvor genannten Oberfläche der Kappe schräg stehende Reflexions- beziehungsweise Leuchtflächen erzeugt werden, die dafür sorgen, dass sich auch bei seitlicher Betrachtung der Leuchtfläche, das heißt aus einer zur zentralen und senkrechten Betrachtungsposition versetzten Position, die oben genannten Wirkungen der Metallbeschichtung einstellen und das Symbol besonders gut und somit insbesondere auch von der Seite zu erkennen ist. Es ist somit dem Verdienst der Erfinder zuzurechnen, einerseits erkannt zu haben, dass die Wirkungen der Metallbeschichtung bei seitlicher Betrachtung der Verbesserung bedürfen und andererseits überraschend festgestellt zu haben, dass diese Verbesserung vergleichsweise einfach und preiswert durch die erfindungsgemäße Konturierung der Metallbeschichtung zu erreichen ist.

Bevorzugt wird die Metallbeschichtung mittels eines PVD (physical vapor deposition)-Verfahrens aufgebracht. Bei den PVD-Verfahren unterscheidet man grundsätzlich zwischen zwei verschiedenen Verfahren. Einerseits gibt es die kostengünstigere Variante des Bedampfens, bei der durch die Zufuhr thermischer Energie bei Niedrigtemperatur schmelzende Metalle verdampft und so auf die Oberfläche des Tastenkörpers aufgebracht werden. Dieses Verfahren wird beispielsweise bei der Bedampfung mit Aluminium oder Kupfer verwendet. Andererseits wird das Sputtern von Substratmaterial, wie beispielsweise Edelstahl, mit Hilfe eines ionisierten Prozessgases eingesetzt. Dabei wird ein Prozessgas (meist Argon) ionisiert und mittels Magnetfeldunterstützung auf das abzuscheidende Material, hier das Target beschleunigt (Magnetronsputtem). Durch lmpulsübertragung der ionisierten Gasatome werden im Vakuum Atome und Atomcluster aus dem Target herausgeschlagen und lagern sich an gewünschter Stelle auf der Oberfläche des Kappenkörpers ab. Derartige Verfahren sind in der DE 103 37 456 A1 beschrieben, deren Offenbarungsgehalt hierin durch Bezugnahme umfasst ist.

Bei Bedarf kann zur Steigerung der Haftfestigkeit eine Vorbehandlung oder Aktivierung der zu beschichtenden Oberfläche des Kappenkörpers vorgenommen werden. Diese Haftsteigerung kann zum Beispiel notwendig sein, wenn die Metallbeschichtung auf der dem Bediener zugewandten Oberfläche des Kappenkörpers aufgebracht ist und von diesem regelmäßig beispielsweise zur Betätigung des zugehörigen Schalters berührt wird oder des Öfteren Kontakt mit vergleichsweise aggressiven Reinigungsflüssigkeiten hat. Mit diesen speziellen Verfahren zur Behandlung von Oberflachen, wie beispielsweise nasschemische Oberflächenvorbehandlungsverfahren, wie Beizen, und physikalische Oberflächenvorbehandlungsverfahren, wie Beflammung (Pyrolyse), Fluorierung, Coronabehandlung und Plasmaverfahren, wird die zu beschichtende Oberfläche vorbehandelt beziehungsweise aktiviert. Durch den Vorgang der Aktivierung wird deren Polarität beziehungsweise deren Oberflächenenergie erhöht, wodurch ein verbessertes Haftvermögen beziehungsweise eine verbesserte Benetzbarkeit erzielt wird.

Die dreidimensionale Kontur der Metallbeschichtung ist durch Beschichtung einer entsprechend ausgestalteten Oberfläche des Kappenkörpers im Bereich der Leucht- beziehungsweise Projektionsfläche erreicht. Dadurch kann vergleichsweise einfach und preiswert die eingangs beschriebene Verbesserung der seitlichen Erkennbarkeit erreicht werden.

Das Symbol wird durch eine aus einer opaken Schicht, beispielsweise aus Lack oder Kunststoff, bestehende Maske definiert. Die Maske ist eine Blende mit einer Lichtdurchlassöffnung, deren Form der Gestalt des darzustellenden Symbols entspricht. Mit einer Maske kann die erfindungsgemäße Kappe besonders preiswert hergestellt werden. Durch die Anordnung der das Leuchtsymbol definierenden Maske unmittelbar um die Leuchtfläche wird eine besonders scharf konturierte Darstellung des Symbols erreicht. Beispielsweise wird die Maske mittels einer opaken Lackschicht, die abschnittsweise beispielsweise mittels Laserbearbeitung entfernt wird, erzeugt. Dadurch kann die erfindungsgemäße Kappe besonders preiswert hergestellt werden. Aufgrund der sehr flexiblen Bearbeitungsmöglichkeiten durch den Laser lassen sich zudem beliebige Symbole auf der Kappe darstellen. In einer anderen Ausgestaltung werden der Kappenkörper aus einem durchscheinenden oder durchsichtigen Kunststoff und die Maske aus einem opaken Kunststoff in einem Mehrkomponenten-Spritzgussverfahren hergestellt. Die Maske wird in einer anderen beispielhaften Ausgestaltung durch Bedruckung gezielt an den gewünschten Stellen aufgebracht. Bei der Maske kann es sich auch um eine partiell opake Folie handeln, die auf den transparenten Kappenkörper aufgebracht, beispielsweise aufgeklebt oder hinterspritzt und verschweißt wird.

Eine weitere vorteilhafte Ausgestaltung zeichnet sich dadurch aus, dass die dreidimensionale Kontur der Metallbeschichtung ein Profil aufweist, das sich wenigstens teilweise von der durch die Maske definierten Ebene in Richtung der dem Bediener zugewandten Oberfläche der Kappe erhebt. Beispielsweise erhebt sich die Metallbeschichtung im Bereich des durch die Maske freigegebenen, lichtdurchlässigen Abschnitts gebirgsartig in Richtung des Betrachters, um so in diesem Bereich zu einer dreidimensionalen Darstellung des Symbols zu führen, wobei die zu dieser Ebene beziehungsweise der Oberfläche der Kappe schräg stehenden Flanken der Metallbeschichtung für eine gesteigerte seitliche Sichtbarkeit sorgen, wobei gleichzeitig die umgebende Maskierung in den dazu abgesenkten Bereichen eine kontrastreiche Darstellung gewährleistet.

Die Metallbeschichtung ist nicht auf einer dem Bediener beziehungsweise dem Betrachter zugewandten Oberfläche des Kappenkörpers, sondern beispielsweise auf der, der Lichtquelle zugewandten, Oberfläche des Kappenkörpers wenigstens im Bereich der Leucht- beziehungsweise Projektionsfläche aufgebracht und befindet sich somit an einer durch den Kappenkörper verdeckten Stelle. Da die Metallbeschichtung daher nicht von dem Bediener berührt werden kann und auch nicht in Kontakt mit Reinigungsflüssigkeiten gerät, ist die Metallbeschichtung nicht abriebgefährdet und es sind keine hohe Anforderungen an ihre chemische Beständigkeit zu stellen. Spezielle Oberflächenvorbehandlungsverfahren zur Steigerung der Haftfähigkeit können somit vorteilhaft entfallen.

Bei einer weiteren vorteilhaften Ausgestaltung weist die Metallbeschichtung bevorzugt eine Dicke von weniger als 5 µm, bevorzugt im Bereich von 5 nm - 50 nm auf. Es hat sich überraschend gezeigt, dass insbesondere ein derartiger Bereich von 5 nm - 50 nm einerseits eine ausreichende Reflexion des Umgebungslichts bereitstellt, andererseits aber noch eine ausreichende Durchlässigkeit des Lichts bei gängigen Lichtquellen wie LEDs bereitgestellt werden kann, dass das "Aufleuchten" des betreffenden Symbols ausreichend gut zu erkennen ist.

Die Metallbeschichtung umfasst in einer vorteilhaften Ausgestaltung wenigstens eine Metallschicht aus wenigstens einem Metall oder Halbmetall wie Sc, Y, Ti, Zr, V, Nb, Ta, Cr, Mo, W, Mn, Fe, Co, Pd, Pt, Cu, Ag, Au, Zn, B, Al, In, Tl, Si, Ge, Sn, Pb, Sb, Bi, Legierungen oder Mischschichten davon und/oder Edelstahl ausgewählt ist. Die verschiedenen Metalle oder mehrere unterschiedliche Metallschichten können vorgesehen sein, um verschiedene optische Effekte, beispielsweise farbige Reflexion, zu erzielen. Beispiele hierzu sind ebenfalls in der DE 103 37 456 A1 offenbart.

In einer vorteilhaften Ausgestaltung der erfindungsgemäßen Kappe ist der Kappenkörper wenigstens im Bereich der Leucht- beziehungsweise Projektionsfläche, bevorzugt der gesamte Kappenkörper, transparent oder durchleuchtend ausgestaltet, ferner ist die Maske auf der dem Schalter beziehungsweise der Lichtquelle zugewandten Innenseite der Kappe und daran angrenzend angeordnet und zwischen der Maske und der Lichtquelle ist die Metallbeschichtung aufgebracht. Durch diese Art der Anordnung lässt sich die erfindungsgemäße Kappe vergleichsweise preiswert herstellen. Der Kappenkörper beziehungsweise die Leucht- beziehungsweise Projektionsfläche kann eingefärbt sein, um dem dargestellten Symbol eine gewünschte Farbe zu verleihen. Die Farbe der opaken Lackschicht ist dabei bevorzugt auf die Reflexionswirkung der darunter angeordneten Metallbeschichtung abgestimmt, so dass bei ausgeschalteter Lichtquelle und einfallendem Umgebungslicht das nicht leuchtende Symbol und der von der opaken Lackschicht bedeckte Bereich wahlweise zum Beispiel hohem Kontrast für eine gute Lesbarkeit des Symbols oder auch geringer Kontrast damit der Betrachter nicht mit momentan unrelevanten Informationen belästigt wird.

Die Erfindung betrifft ferner ein Bedienelement, das die zuvor beschriebene Kappe in den zuvor beschriebenen Ausgestaltungen und mit den jeweils beschriebenen Vorteilen umfasst. Das Bedienelement ist beispielsweise ein Drehschalter. Bevorzugt handelt es sich bei dem Bedienelement um einen Tastschalter und bei der Bedienelementkappe entsprechend um eine Tastkappe.

Die Erfindung betrifft ferner ein Anzeigeelement, das die zuvor beschriebene Kappe in den zuvor beschriebenen Ausgestaltungen und mit den jeweils beschriebenen Vorteilen umfasst. Das zuvor erwähnte Anzeige- oder Bedienelement findet vorteilhaft Verwendung in einem Kraftfahrzeug, in einem Haushaltsgerät, insbesondere bei sogenannter weißer Ware, oder einem Unterhaltungselektronikgerät. Nicht zuletzt aufgrund der sehr stark variierenden Lichtverhältnisse findet es bevorzugt Verwendung in einem Kraftfahrzeug, wo es beispielsweise in ein Armaturenbrett oder ein Bedienfeld integriert ist.

Die Erfindung betrifft ferner ein Verfahren zur Herstellung einer Kappe für eine Anzeige- und/oder Bedienelement in einer der zuvor beschriebenen Ausführungsformen. Dabei wird in einem ersten Schritt der transparente oder durchscheinende Kappenköper aus Polycarbonat, beispielsweise Lexan^{®}, hergestellt. Simultan oder in einem weiteren separaten Schritt wird die opake, eine Maske bildende Schicht, die auf der der Lichtquelle zugewandten Innenseite des Kappenkörpers aufgebracht ist und eine Leuchtfläche definiert, hergestellt. Bis auf die Öffnung der Maske bleibt die Innenseite, das heißt der der Lichtquelle beziehungsweise dem Schalter zugewandten Seite des Kappenkörpers somit lichtdicht abgeschottet. Dabei weist der Kappenkörper im Bereich der durch die Maske definierten Leuchtfläche eine dreidimensionale Kontur auf, die sich auf die in einem weiteren Schritt auf die Metallbeschichtung überträgt, die mittels eines PVD-Verfahrens wenigstens auf die durch die Maske definierte Leuchtfläche aufgebracht wird. In einem oder mehreren weiteren optionalen Schritten wird der Kappenkörper auf der dem Bediener und/oder der Lichtquelle zugewandten Seite mit einem transparenten oder durchscheinenden gegebenenfalls auch eingefärbten Schutzlack überzogen.

In einer weiteren vorteilhaften Ausgestaltung des zuvor genannten erfindungsgemäßen Verfahrens werden der Kappenkörper und die opake Schicht in einem Mehrkomponenten-Spritzgussverfahren oder durch Hinterspritzen einer opaken Folie in einem gemeinsamen Schritt hergestellt oder alternativ wird die opake Schicht in einer der Herstellung des Kappenkörpers nachfolgenden Schritt durch Bedrucken auf den Kappenkörper aufgebracht.

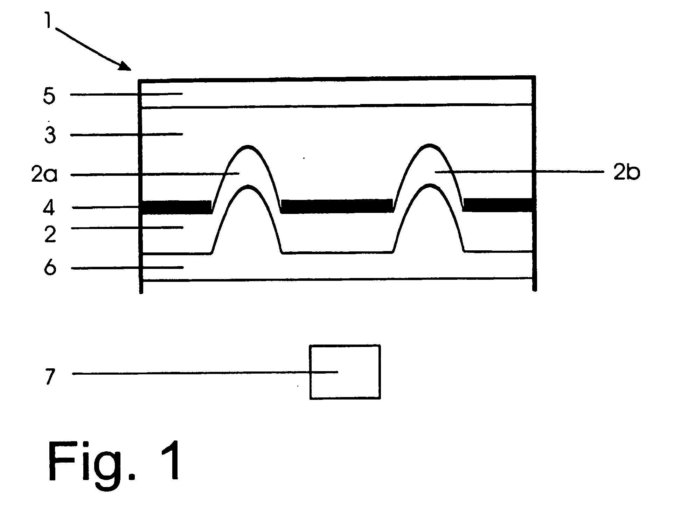

In der beigefügten Figur ist eine bevorzugte Ausführungsform der erfindungsgemäßen Bedienelementkappe dargestellt, ohne die Erfindung darauf zu beschränken, wobei
- Figur 1: eine schematische Seitenschnittansicht der erfindungsgemäßen Anzeigebeziehungsweise Bedienelementkappe zeigt. Da die Darstellung lediglich der Anschauung dient, handelt es sich nicht um eine maßstabsgetreue Darstellung.

Fig. 1 zeigt eine erfindungsgemäße Anzeige- beziehungsweise Bedienelementkappe, die allgemein mit 1 bezeichnet ist. Die Kappe 1 umfasst einen transparenten und/oder transluzenten Kappenköper 3 aus Polycarbonat, beispielsweise Lexan^{®}, der in einem Spritzguss- oder Tiefziehverfahren hergestellt wird. Auf der dem Schalter beziehungsweise der Lichtquelle 7 zugewandten Innenseite des Kappenkörpers 3 (in der Figur die untere Seite des Kappenkörpers 3) ist eine opake Kunststoffschicht, Kunststofffolie, Lackschicht, Mehrkomponenten-Spritzguß aufgebracht. Diese opake Schicht 4 weist Durchbrüche auf, um so eine Maske zu bilden, deren Durchbrüche ein Symbol definieren. Die Unterseite des Kappenkörpers 3 ist im Bereich der Durchbrüche der opaken Schicht 4 nicht eben ausgebildet sondern weist eine dreidimensionale Struktur auf, die sich zur der dem Bediener zugewandten Oberfläche (in der Figur die Oberseite) der Kappe 1 erhebt. Auf der durch die Maske 4 beziehungsweise den Kappenkörper 3 im Bereich der Durchbrüche der Maske 4 vorgegebenen Innenfläche ist eine transluzente Metallbeschichtung 2 mittels eines PVD-Verfahrens aufgebracht. Aufgrund der dreimensionalen Kontur des Kappenkörpers 3 im Bereich der Durchbrüche der Maske 4 weist die Metallbeschichtung 2 ebenfalls eine entsprechende dreidimensionale Kontur auf, wie die Schnittprofile 2a und 2b zeigen. Es wird an dieser Stelle nur zur Verdeutlichung darauf hingewiesen, dass die Größenverhältnisse, insbesondere die Dicken der Schichten 2, 3, 4, 5, 6, nur prinzipiell und skizzenhaft dargestellt sind, da im Besonderen eine transluzente PVD-Schicht 2 sehr dünn, das heißt 10 nm bis 200 nm bevorzugt 50 nm bis 100 nm dick ist. Dadurch ergibt sich eine nicht ebene Leucht-fläche, sondern deren zur Oberseite der Kappe 1 schräge Flächen sorgen für eine verbesserte seitliche Erkennbarkeit dieser Leuchtfläche.

Zum Schutz der Metallbeschichtung 2 ist optional ein transparenter oder durchscheinender Schutzlack 6 auf der Metallbeschichtung 2 vollflächig aufgebracht. Der Kappenkörper 3 ist, optional, das heißt ohne oder mit auf der dem Bediener zugewandten Seite mit einem transparenten, beispielsweise hochglänzenden, gegebenenfalls auch eingefärbten Schutzlack 5 überzogen. Im eingebauten Zustand der Kappe 1, befindet sich unterhalb der Kappe 1 eine Lichtquelle 7, beispielsweise ein LED. Licht dieser Licht- quelle 7 durchdringt den durchscheinenden oder transparenten Lack 6, die lichtdurchlässige Metallbeschichtung 2 und lässt aufgrund der durch die opake Schicht 3 erzeugten Maske das Symbol im Bereich der Durchbrüche der Maske 3 leuchten.

Dieses ist von der Bedienerseite her durch den transparenten Schutzlack 5 und den durchscheinenden oder transparenten Kappenkörper 3 sichtbar. Aufgrund der dreidimensionalen Kontur 2a, 2b der Metallbeschichtung 2 erscheint das Symbol bei eingeschalteter Lichtquelle 7 nicht flächig sondern dreidimensional und ist daher gut auch unter einem schiefen Winkel, wobei unter schiefen Winkel eine Blickrichtung eines Insassen im Kraftfahrzeug auf das Bedienelement 3 aus einer nicht senkrechten Richtung zu verstehen ist, erkennbar.

## Patentansprüche

1. Kappe (1) für ein Anzeige- und/oder Bedienelement, umfassend einen Kappenkörper (3) zur Abdeckung einer Lichtquelle (7) gegebenenfalls auch zur Betätigung eines Schalters eines zugehörigen Bedienelements, wobei in dem Kappenkörper (3) eine Leucht- beziehungsweise Projektionsfläche so ausgestaltet ist, dass durch Bestrahlung durch eine Lichtquelle (7) ein auf der oder durch die Leucht- beziehungsweise Projektionsfläche dargestelltes Symbol auf einer Bedienerseite des Anzeige- und/oder Bedienelements sichtbar wird, wobei die Leuchtbeziehungsweise Projektionsfläche eine lichtdurchlässige, durch ein PVD-Verfahren aufgebrachte, Metallbeschichtung (2) umfasst und das Symbol durch eine aus einer opaken Schicht, beispielsweise aus Lack oder Kunststoff, bestehenden Maske (4) definiert ist, **dadurch gekennzeichnet, dass** die Metallbeschichtung (2) eine dreidimensionale Kontur (2a, 2b) zur Darstellung des Symbols aufweist, und dass die dreidimensionale Kontur (2a, 2b) der Metallbeschichtung durch Beschichtung einer entsprechend ausgestalteten Oberfläche des Kappenkörpers (3) im Bereich der Leucht- beziehungsweise Projektionsfläche erreicht ist.

2. Kappe (1) für ein Anzeige- und/oder Bedienelement nach dem vorhergehenden Anspruch, **dadurch gekennzeichnet, dass** die dreidimensionale Kontur (2a, 2b) der Metallbeschichtung (2) ein Profil aufweist, das sich wenigstens teilweise von der durch die Maske (4) definierten Ebene in Richtung der dem Bediener zugewandten Oberfläche der Kappe (1) erhebt.

3. Kappe (1) für ein Anzeige- und/oder Bedienelement nach einem der vorhergehenden Ansprüche, **dadurch gekennzeichnet, dass** die Metallbeschichtung (2) nicht auf einer dem Betrachter beziehungsweise dem Bediener zugewandten Oberfläche des Kappenkörpers (3), sondern beispielsweise auf der der Lichtquelle zugewandten Oberfläche des Kappenkörpers (3), wenigstens im Bereich der Leucht- beziehungsweise Projektionsfläche aufgebracht ist.

4. Kappe (1) für ein Anzeige- und/oder Bedienelement nach einem der vorhergehenden Ansprüche, **dadurch gekennzeichnet, dass** die Metallbeschichtung (2) eine Dicke von weniger als 5 µm, bevorzugt im Bereich von 10 nm bis 200 nm aufweist.

5. Kappe (1) für ein Anzeige- und/oder Bedienelement nach einem der vorhergehenden Ansprüche, **dadurch gekennzeichnet, dass** die Metallbeschichtung (2) wenigstens eine Metallschicht mit wenigstens einem Metall oder Halbmetall wie Sc, Y, Ti, Zr, V, Nb, Ta, Cr Mo, W, Mn, Fe, Co, Pd, Pt, Cu, Ag, Aul Zn, B, AI, Inl Tl, Si, Ge, Sn, Pb, Sb, Bi, Legierungen oder Mischschichten davon und/oder Edelstahl ausgewählt ist.

6. Kappe (1) für ein Anzeige- und/oder Bedienelement nach einem der vorhergehenden Ansprüche, **dadurch gekennzeichnet, dass** der Kappenkörper (3) wenigstens im Bereich der Leucht- beziehungsweise Projektionsfläche, bevorzugt der gesamte Kappenkörper, transparent oder durchleuchtend ausgestaltet ist und dass die Maske (4) im Kappenkörper (3) oder auf der dem Schalter oder der Lichtquelle (7) zugewandten Innenfläche des Kappenkörpers (3) und daran angrenzend angeordnet ist.

7. Kappe (1) für ein Anzeige- und/oder Bedienelement nach einem der vorhergehenden Ansprüche, **dadurch gekennzeichnet, dass** auf die Metallbeschichtung (2) eine transparente oder durchscheinende Schutzlackschicht (6) aufgebracht ist.

8. Anzeige- und/oder Bedienelement **gekennzeichnet durch** eine Bedienelementkappe (1) nach einem der vorhergehenden Ansprüche.

9. Bedienelement nach dem vorhergehenden Anspruch, **dadurch gekennzeichnet, dass** das Bedienelement ein Tastschalter ist und die Bedienelementkappe eine Tastkappe (1) ist.

10. Verwendung des Anzeige- und/oder Bedienelements nach einem der beiden vorhergehenden Ansprüche in einem Kraftfahrzeug, in einem Haushaltsgerät oder einem Unterhaltungselektronikgerät, bevorzugt in einem Kraftfahrzeug.

11. Verfahren zur Herstellung einer Kappe für eine Anzeige- und/oder Bedienelement nach einem der Ansprüche 1 bis 7, wobei in einem ersten Schritt der transparente oder durchscheinende Kappenköper aus Polycarbonat, beispielsweise Lexan®, hergestellt wird und simultan oder in einem weiteren Schritt die opake, eine Maske bildende Schicht, die auf der der Lichtquelle zugewandten Innenseite des Kappenkörpers aufgebracht ist und eine Leuchtfläche definiert, hergestellt wird, wobei der Kappenkörper im Bereich der durch die Maske definierten Leuchtfläche eine dreidimensionale Kontur aufweist, in einem weiteren Schritt die Metallbeschichtung mittels eines PVD-Verfahrens wenigstens auf die durch die Maske definierte Leuchtfläche aufgebracht wird und in einem oder mehreren weiteren optionalen Schritten der Kappenkörper auf der dem Bediener und/oder der Lichtquelle zugewandten Seite mit einem transparenten oder durchscheinenden Schutzlack überzogen wird.

12. Verfahren gemäss dem vorhergehenden Anspruch, wobei Kappenkörper und die opake Schicht in einem Mehrkomponenten-Spritzgussverfahren oder durch Hinterspritzen einer opaken Folie in einem gemeinsamen Schritt hergestellt werden oder alternativ die opake Schicht in einer der Herstellung des Kappenkörpers nachfolgenden Schritt durch Bedrucken auf den Kappenkörper aufgebracht wird.

## Claims

1. Cap (1) for a display and/or control element, comprising a cap member (3) for covering a light source (7), optionally also for actuating a switch of an associated control element, wherein a luminous or projection area in the cap member (3) is designed such that a symbol depicted on or through the luminous or projection area becomes visible on an operator side of the display and/or control element as a result of illumination by a light source (7), wherein the luminous or projection area includes a light-transmlssive metal coating (2) applied by means of a PVD process, and the symbol is defined by a mask (4) consisting of an opaque layer, for example of paint or plastic, **characterised in that** the metal coating (2) has a three-dimensional contour (2a, 2b) for depicting the symbol, and that the three-dimensional contour (2a, 2b) of the metal coating is obtained by coating an appropriately designed surface of the cap member (3) in the region of the luminous or projection area.

2. Cap (1) for a display and/or control element according to the preceding claim, **characterised in that** the three-dimensional contour (2a, 2b) of the metal coating (2) has a profile that, at least in part, is raised from the plane defined by the mask (4) in the direction of the surface of the cap (1) facing the operator.

3. Cap (1) for a display and/or control element according to any one of the preceding claims, **characterised in that** the metal coating (2) is not deposited on a surface of the cap member (3) facing the observer or operator, but, for example, on the surface of the cap member (3) facing the light source, at least in the region of the luminous or projection area.

4. Cap (1) for a display and/or control element according to any one of the preceding claims, **characterised in that** the metal coating (2) has a thickness of less than 5 µm, preferably in the range from 10 nm to 200 nm.

5. Cap (1) for a display and/or control element according to any one of the preceding claims, **characterised in that** the metal coating (2) is at least one metal layer selected from at least one metal or semimetal such as Sc, Y, Ti, Zr, V, Nb, Ta, Cr, Mo, W, Mn, Fe, Co, Pd, Pt, Cu, Ag, Au, Zn, B, Al, In, TI, Si, Ge, Sn, Pb, Sb, Bi, alloys or mixed layers thereof, and/or stainless steel.

6. Cap (1) for a display and/or control element according to any one of the preceding claims, **characterised in that** the cap member (3), at least in the region of the luminous or projection area, preferably the entire cap member, is designed to be transparent or translucent and **in that** the mask (4) is located in the cap member (3) or on the inner side of the cap member (3) facing the switch or light source (7) and adjacent thereto.

7. Cap (1) for a display and/or control element according to any one of the preceding claims, **characterised in that** a transparent or translucent protective paint layer (6) is deposited on the metal coating (2).

8. Display and/or control element, **characterised by** a control element cap (1) according to any one of the preceding claims.

9. Control element according to the preceding claim, **characterised in that** the control element is a pushbutton and the control element cap is a pushbutton cap (1).

10. Use of the display and/or control element according to any one of the two preceding claims in a motor vehicle, in a household appliance, or in an electronic entertainment device, preferably in a motor vehicle.

11. Method for producing a cap for a display and/or control element according to any one of the claims 1 to 7, wherein in a first step the transparent or translucent cap member is produced from polycarbonate, for example Lexan®, and simultaneously or in a separate step, the opaque layer which forms a mask and is deposited on the inner side of the cap member facing the light source and defines a luminous area, is produced, wherein the cap member has a three-dimensional contour in the region of the luminous area defined by the mask, in an additional step the metal coating is deposited by means of a PVD process at least onto the luminous area defined by the mask, and in one or more further optional steps the cap member is coated with a transparent or translucent protective paint on the side facing the operator and/or on the side facing the light source.

12. Method according to the preceding claim, wherein the cap member and the opaque layer are produced by a multicomponent injection moulding method or by back-injection moulding of an opaque film in a joint step, or alternatively the opaque layer is applied to the cap member by printing in a step subsequent to the production of the cap member.

## Revendications

1. Capuchon (1) pour un élément d'affichage et/ou de commande, comprenant un corps de capuchon (3) destiné à recouvrir une source de lumière (7), le cas échéant également à commander un interrupteur d'un élément de commande associé, dans ledit corps de capuchon (3), une surface lumineuse ou bien de projection étant réalisée de manière à ce que, par une exposition aux rayons d'une source lumineuse (7), un symbole représenté sur ou par ladite surface lumineuse ou bien de projection devienne visible sur une face opérateur dudit élément d'affichage et/ou de commande, ladite surface lumineuse ou bien de projection comprenant un revêtement de métal (2) transparent appliqué au moyen d'un procédé PVD et ledit symbole étant défini par une masque (4) se composant d'une couche opaque, par exemple en vernis ou en matière plastique, **caractérisé par le fait que** ledit revêtement de métal (2) présente un contour à trois dimensions (2a, 2b) pour la représentation du symbole et que ledit contour à trois dimensions (2a, 2b) du revêtement de métal est obtenu en revêtant une surface du corps de capuchon (3), réalisée de manière correspondante, au niveau de ladite surface lumineuse ou bien de projection.

2. Capuchon (1) pour un élément d'affichage et/ou de commande, selon la revendication précédente, **caractérisé par le fait que** ledit contour à trois dimensions (2a, 2b) du revêtement de métal (2) présente un profil qui s'élève au moins en partie à partir du plan défini par ladite masque (4), en direction de la surface du capuchon (1) qui est tournée vers l'opérateur.

3. Capuchon (1) pour un élément d'affichage et/ou de commande, selon l'une quelconque des revendications précédentes, **caractérisé par le fait que** ledit revêtement de métal (2) n'est pas appliqué sur une surface du corps de capuchon (3) tournée en direction de l'observateur ou bien de l'opérateur, mais est appliqué par exemple sur la surface du corps de capuchon (3) tournée vers ladite source de lumière, au moins au niveau de ladite surface lumineuse ou bien de projection.

4. Capuchon (1) pour un élément d'affichage et/ou de commande, selon l'une quelconque des revendications précédentes, **caractérisé par le fait que** ledit revêtement de métal (2) présente une épaisseur inférieure à 5 µm, de préférence comprise entre 10 nm et 200 nm.

5. Capuchon (1) pour un élément d'affichage et/ou de commande, selon l'une quelconque des revendications précédentes, **caractérisé par le fait que** ledit revêtement de métal (2) comprend au moins une couche de métal qui est choisie dans au moins un métal ou semi-métal, tel que Sc, Y, Ti, Zr, V, Nb, Ta, Cr, Mo, W, Mn, Fe, Co, Pd, Pt, Cu, Ag, Au, Zn, B, Al, In, TI, Si, Ge, Sn, Pb, Sb, Bl, des alliages ou couches mixtes de ceux-cl et/ou l'acier spécial.

6. Capuchon (1) pour un élément d'affichage et/ou de commande, selon l'une quelconque des revendications précédentes, **caractérisé par le fait que** ledit corps de capuchon (3) est réalisé de façon transparente ou translucide au moins au niveau de ladite surface lumineuse ou bien de projection, de préférence l'ensemble du corps de capuchon est réalisé ainsi, et que ladite masque (4) est disposée à l'intérieur du corps de capuchon (3) ou sur la face interne du corps de capuchon (3), tournée en direction de l'Interrupteur ou de la source de lumière (7), et de manière à être y contiguë.

7. Capuchon (1) pour un élément d'affichage et/ou de commande, selon l'une quelconque des revendications précédentes, **caractérisé par le fait que** sur ledit revêtement de métal (2) est appliquée une couche de vernis protecteur (6) transparente ou translucide.

8. Elément d'affichage et/ou de commande, **caractérisé par** un capuchon d'élément de commande (1) selon l'une quelconque des revendications précédentes.

9. Elément de commande selon la revendication précédente, **caractérisé par le fait que** ledit élément de commande est un poussoir et que ledit capuchon d'élément de commande est un capuchon-poussoir (1).

10. Utilisation de l'élément d'affichage et/ou de commande selon l'une quelconque des deux revendications précédentes, dans un véhicule automobile, dans un appareil électroménager ou dans un appareil de l'électronique de divertissement, de préférence dans un véhicule automobile.

11. Procédé de fabrication d'un capuchon pour un élément d'affichage et/ou de commande selon l'une quelconque des revendications 1 à 7, dans lequel on réalise, dans une première étape, le corps de capuchon transparent ou translucide en polycarbonate, par exemple en Texan®, et, simultanément ou dans une autre étape, on réalise la couche opaque formant masque qui est appliquée sur la face interne du corps de capuchon, tournée vers la source de lumière, et qui définit une surface lumineuse, ledit corps de capuchon présentant un contour à trois dimensions au niveau de la surface lumineuse définie par la masque, dans une autre étape, on applique le revêtement de métal au moyen d'un procédé PVD au moins sur ladite surface lumineuse définie par la masque, et, dans une ou plusieurs autre(s) étape(s) optionnelle(s), ledit corps de capuchon est revêtu, sur la face montrant en direction de l'opérateur et/ou de la source de lumière, d'un vernis protecteur transparent ou translucide.

12. Procédé selon la revendication précédente, dans lequel ledit corps de capuchon et ladite couche opaque sont réalisés, dans une étape commune, dans un processus de moulage par injection à plusieurs composants ou par surmoulage d'une feuille opaque par injection, ou, alternativement, la couche opaque est appliquée par impression sur le corps de capuchon dans une étape suivant la réalisation du corps de capuchon.
